# EUROPEAN PATENT SPECIFICATION

(11) **EP 2 955 850 B1**
(45) Date of publication and mention of the grant of the patent: **23.06.2021**
(21) Application number: 15166254.1
(22) Date of filing: 04.05.2015
(51) Int. Cl.: H03K 17/96

(54) **OPTICAL SWITCH AND CONTROL METHOD THEREOF**
OPTISCHER SCHALTER UND STEUERUNGSVERFAHREN FÜR EINEN SOLCHEN
COMMUTATEUR OPTIQUE ET SON PROCÉDÉ DE COMMANDE

(30) Priority: 11.06.2014 JP 2014120627
(43) Date of publication of application: 16.12.2015
(73) Proprietor: Yokogawa Electric Corporation, Tokyo (JP)
(72) Inventor: Endo, Tatsuro, Tokyo (JP)
(74) Representative: Henkel & Partner mbB

(56) References cited:
- WO-A1-2007/006331
- DE-C1- 19 639 285
- None

## Description

### BACKGROUND OF THE INVENTION

### Field of the Invention

The disclosure relates to an optical switch, a field device, and a control method of an optical switch.

Priority is claimed on Japanese Patent Application No. 2014-120627, filed June 11, 2014.

### Description of Related Art

Because field devices which are installed in a plant or a factory require explosion-proof, water-proof, dust-proof, damp-proof, and so on, most of the field devices are equipped with an optical switch emitting infrared light or visible light. The optical switch is equipped with a light emitter and a light receiver disposed on a back side of a glass plate which is disposed in an operation panel of the field device. The optical switch emits light (infrared light or visible light) from the light emitter to the glass plate at a certain frequency (for example, several tens of hertz). The optical switch determines whether the operation panel (switch) is operated or not by determining whether the light receiver receives the reflected light or not.

For example, in a case where a worker operates the operation panel, because a reflector (a finger of the worker) exists on a front side of the glass plate disposed in the operation panel, the light receiver receives the light reflected by the reflector. For the reason, the optical switch determines that the operation panel is operated. On the other hand, in a case where the worker does not operate the operation panel, because the reflector does not exist on the front side of the glass plate disposed in the operation panel, the light receiver does not receive light. For the reason, the optical switch determines that the operation panel is not operated. Examples of the optical switch are disclosed in Japanese Unexamined Patent Application Publication No. 2003-37563 and Japanese Unexamined Patent Application Publication No. 2008-232707.

The light receiver receives the reflected light of the pulsed light emitted by the light emitter, and the optical switch determines whether the operation panel is operated or not. For the reason, if a frequency for driving the light emitter is increased, responsiveness can be improved. Taking an extreme example so as to easily understand, as compared to a case where the emission frequency of the light emitter is set to 1 [Hz], in a case where the emission frequency of the light emitter is set to 100 [Hz], the optical switch can determine whether the operation panel is operated or not in a short time about one-hundredth.

However, if the emission frequency becomes higher, a life of a light emitting element disposed in the light emitter is decreased. If the life of the light emitting element is decreased, maintenance of the optical switch (for example, exchanging the light emitter) is conducted more frequently, load of the worker is increased, and costs are also increased. For the reason, there is a need to prevent from decreasing the life of the light emitting element as much as possible. As described above, considering the life of the light emitting element, the emission frequency of the light emitter cannot be higher than a certain value.

DE 196 39 285 C1 discloses a circuit device connected to at least one optical sensor for a non-contact controlled toilet flush with an electrically controllable valve for switching water on and off. The sensor has a light transmitter and at least one light detector. The transmitter is excited time-wise to generate light pulses. The pulse time of the light pulse is increased to a fixed value when the sensor measures no use of the flush during a predetermined time interval. The pulse time of the pulse is reduced back to its start value as soon as the sensor detects use of the flush.

WO 2007/006331 A1 discloses an automatic dispenser for dispensing lengths of paper for use as hand towels, including an IR sensor system for detecting a user. The sensor system scans at a first scanning rate and also at a second higher scanning rate. When the sensor system detects a user, it changes the scanning rate from the first to the second rate.

### SUMMARY

According to the present invention, there is provided an optical switch as outlined in independent claim 1, a field device as outlined in claim 8 and a control method as outlined in independent claim 9. Advantageous developments are defined in the dependent claims.

Further features and aspects of the present disclosure will become apparent from the following detailed description of exemplary embodiments with reference to the attached drawings.

The scope of the invention is defined in the appended claims. Any reference to "embodiment(s)", "example(s)" or "aspect(s) of the invention" in this description not falling under the scope of the claims should be interpreted as illustrative example(s) for understanding the invention.

### BRIEF DESCRIPTION OF THE DRAWINGS

FIG. 1 is a block diagram illustrating a main configuration of a field device in a present embodiment.
FIG. 2 is a flowchart illustrating operations of the optical switch in the present embodiment.
FIG. 3 is a drawing illustrating wave shapes of the signals in the optical switch in the present embodiment.

### DETAILED DESCRIPTION OF THE EMBODIMENTS

The embodiments of the present invention will be now described herein with reference to illustrative preferred embodiments. Those skilled in the art will recognize that many alternative preferred embodiments can be accomplished using the teaching of the present invention and that the present invention is not limited to the preferred embodiments illustrated herein for explanatory purposes, but only to the scope of the appended claims.

An aspect of some embodiments of the present invention is to provide an optical switch, a field device, and a control method of an optical switch which can extend the life of the optical switch and improve the responsiveness of the optical switch.

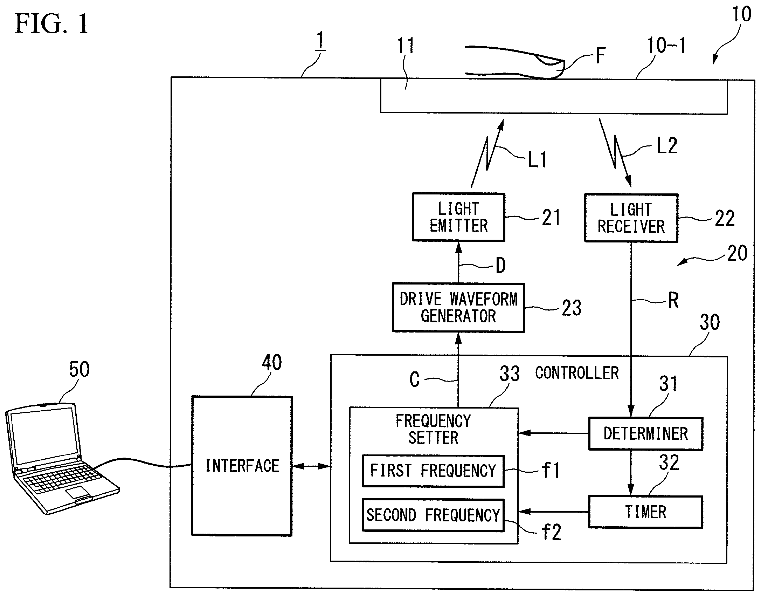

The optical switch, the field device, and the control method of the optical switch of the embodiments of the present invention will be described below with reference to drawings. FIG. 1 is a block diagram illustrating a main configuration of a field device in a present embodiment. As shown in FIG. 1, the field device 1 is equipped with an operation panel 10, an emitter-receiver 20, controller 30, and an interface 40. The field device 1 is installed in a field of a plant or a factory. The field device 1 preforms at least one of a measurement and a manipulation which are necessary for controlling various types of processes under the control of a control unit (not shown).

Specifically, the field device 1 is such as a sensor device (for example, a flowmeter and a temperature sensor), a valve device (for example, a flow control valve and an on-off valve), an actuator device (for example, a fan and a motor), an imaging device (for example, a camera and a video camera for recording circumstances and objects in the plant), a sound device (for example, a microphone collecting abnormal noise in the plant, and a speaker generating alarm sound), a position detection device outputting a position information of each device, and other devices.

For example, the operation panel 10 is disposed on a front side of the field device 1. The operation panel 10 is operated by a field worker (user). A transparent plate 11 is disposed in the operation panel 10. When the user operates the operation panel 10, a finger F (reflector) of the user touches the transparent plate 11. The transparent plate 11 is made of material through which the light emitted from the emitter-receiver 20 (the light reflected by the finger F) passes. For example, the transparent plate 11 is made of glass.

The emitter-receiver 20 is equipped with a light emitter 21, a light receiver 22, and a drive waveform generator 23. The emitter-receiver 20 is disposed on a back side of the transparent plate 11 disposed in the operation panel 10. Specifically, the emitter-receiver 20 is disposed on a surface 10-1 of the operation panel 10 opposite to the side where the finger F of the user touches. The emitter-receiver 20 emits the pulsed light (hereinafter "pulsed light L1") toward the operation panel 10, and the emitter-receiver 20 receives the light (hereinafter "reflected pulsed light L2") from the the operation panel 10.

The light emitter 21 is equipped with a light emitting element such as an LED (Light Emitting Diode) or an LD (Laser Diode). The light emitter 21 is driven by the drive waveform generator 23, and the light emitter 21 emits the pulsed light L1 toward the operation panel 10. Specifically, the light emitter 21 is driven in accordance with a driving signal D output from the drive waveform generator 23, and the light emitter 21 emits the pulsed light L1 having wavelength of infrared light or visible light at a certain emission frequency from several hertz to several tens of hertz.

The light receiver 22 is equipped with a light receiving element such as a photodiode. The light receiver 22 receives the reflected pulsed light L2 from the operation panel 10. The light receiver 22 outputs a light receiving signal R having amplitude according to intensity of the reflected pulsed light L2 received by the light receiver 22. In a case where the finger F exists on a predetermined position of the transparent plate 11 disposed in the operation panel, the reflected pulsed light L2 from the operation panel 10 can be received. However, in a case where the finger F does not exist on the predetermined position of the transparent plate 11, the reflected pulsed light L2 cannot be received.

The drive waveform generator 23 generates the driving signal D for driving the light emitter 21 under the control of the controller 30. Specifically, the drive waveform generator 23 generates, as the driving signal D, a rectangular-shaped pulse signal having the same frequency (from several hertz to several tens of hertz) as the emission frequency of the pulsed light L1 emitted by the light emitter 21. Although details will be described later, in a case where the user does not operate the operation panel 10, the frequency of the driving signal D is set to several hertz (for example, 5 [Hz]). On the other hand, in a case where the user operates the operation panel 10, the frequency of the driving signal D is set to several tens of hertz (for example, 30 [Hz]).

The controller 30 is equipped with a CPU (Central Processing Unit), a volatile memory such as a RAM (Random Access Memory), and a non-volatile memory such as a flash memory. The controller 30 totally controls the operation of the field device 1. In the controller 30, the CPU executes one or more programs stored in the non-volatile memory so as to implement a determiner 31, a timer 32, and a frequency setter 33. The optical switch is equipped with the determiner 31, the timer 32, and the frequency setter 33, along with the emitter-receiver 20.

The determiner 31 determines whether the operation panel 10 is operated or not by determining whether the determiner 31 receives the light receiving signal R or not, and the determiner 31 outputs the result of the determination. Specifically, in a case where the amplitude of the light receiving signal R does not exceed a predetermined threshold value (in a case where the light receiving signal R is not received), the determiner 31 determines that the operation panel 10 is not operated, and the determiner 31 outputs a determination result "OFF" (first result) to the timer 32 and the frequency setter 33. On the other hand, in a case where the amplitude of the light receiving signal R exceeds the predetermined threshold value (in a case where the light receiving signal R is received), the determiner 31 determines that the operation panel 10 is operated, and the determiner 31 outputs a determination result "ON" (second result) to the timer 32 and the frequency setter 33. The threshold value is a predetermined threshold value for determining whether the operation panel 10 is operated or not.

The determination result output from the determiner 31 is input to the timer 32. The timer 32 measures time in accordance with the determination result output from the determiner 31. Specifically, the timer 32 measures the time (on-time) of continuing to output the determination result "ON" from the determiner 31, and the timer 32 measures the time (off-time) of continuing to output the determination result "OFF" from the determiner 31. For example, the timer 32 is implemented by an on-time counter and an off-time counter. When the determination result which is output from the determiner 31 is changed from the "OFF" to the "ON", the on-time counter starts to count the on-time at a constant period. Thereafter, when the result of the determination made by the determiner 31 is changed to the "OFF", the on-time counter clears the count value. On the other hand, when the determination result which is output from the determiner 31 is changed from the "ON" to the "OFF", the off-time counter starts to count the off-time at a constant period. Thereafter, when the result of the determination made by the determiner 31 is changed to the "ON", the off-time counter clears the count value.

The frequency setter 33 changes the emission frequency of the light emitter 21 by controlling the drive waveform generator 23 in accordance with the result of the determiner 31. In a case where the operation panel 10 is not operated, the frequency setter 33 basically generates a controlling signal C for setting the emission frequency of the light emitter 21 to a first emission frequency f1. On the other hand, in a case where the operation panel 10 is operated, the frequency setter 33 basically generates a controlling signal C for setting the emission frequency of the light emitter 21 to a second emission frequency f2.

The first emission frequency f1 is a frequency for determining the emission frequency of the light emitter 21 in a case where the operation panel 10 is not operated. The first emission frequency f1 is set to a low frequency (for example, about 5 [Hz]) so as not to decrease the life of the light emitting element disposed in the light emitter 21. The second emission frequency f2 is a frequency for determining the emission frequency of the light emitter 21 in a case where the operation panel 10 is operated. The second emission frequency f2 is set to a high frequency (for example, about 30 [Hz]) which is higher than the first emission frequency f1 so as to improve responsiveness.

The first emission frequency f1 and the second emission frequency f2 are preliminarily stored in the frequency setter 33. The first emission frequency fl and the second emission frequency f2 can be changed in accordance with an instruction from the operation panel 10 or an instruction from an external device 50 connected to the interface 40. Both the first emission frequency f1 and the second emission frequency f2 may be changed, and only one of the first emission frequency f1 and the second emission frequency f2 may be changed.

The frequency setter 33 changes the emission frequency of the light emitter 21 with reference to the measurement result of the timer 32 in addition to the determination result of the determiner 31. Specifically, in a case where the off-time measured by the timer 32 equals to a predetermined time period Ty (for example, about 5 seconds: first period) after the frequency setter 33 generates the controlling signal C for setting the emission frequency of the light emitter 21 to the second emission frequency f2, the frequency setter 33 generates the controlling signal C for setting the emission frequency of the light emitter 21 to the first emission frequency fl. In this case, because the operation panel 10 is not continuously operated, so as to extend the life of the light emitting element disposed in the light emitter 21, the emission frequency of the light emitter 21 is changed to be lower.

In a case where the on-time measured by the timer 32 equals to a predetermined time period Tx (for example, about several minutes: second period), the frequency setter 33 forcibly generates the controlling signal C for setting the emission frequency of the light emitter 21 to the first emission frequency f1. In this case, because it seems that foreign substances are adhered to the operation panel 10 and the determiner 31 determines wrongly, so as to extend the life of the light emitting element disposed in the light emitter 21, the emission frequency of the light emitter 21 is forcibly changed to be lower. In a case where the frequency setter 33 forcibly generates the controlling signal C for setting the emission frequency of the light emitter 21 to the first emission frequency f1, the frequency setter 33 keeps the first emission frequency fl until the determination result of the determiner 31 becomes the "OFF".

The interface 40 is a device for connecting the external device 50 such as a personal computer to the field device 1. For example, the interface 40 is equipped with a USB (Universal Serial Bus) communicator, a communicator of infrared light, a communicator of NFC (Near field communication), or another communicator. The interface 40 performs a wired or wireless communication with the external device 50 under the control of the controller 30. The frequency setter 33 can change at least one of the first emission frequency f1 and the second emission frequency f2 stored in the frequency setter 33 in accordance with an instruction from the external device 50 connected to the interface 40.

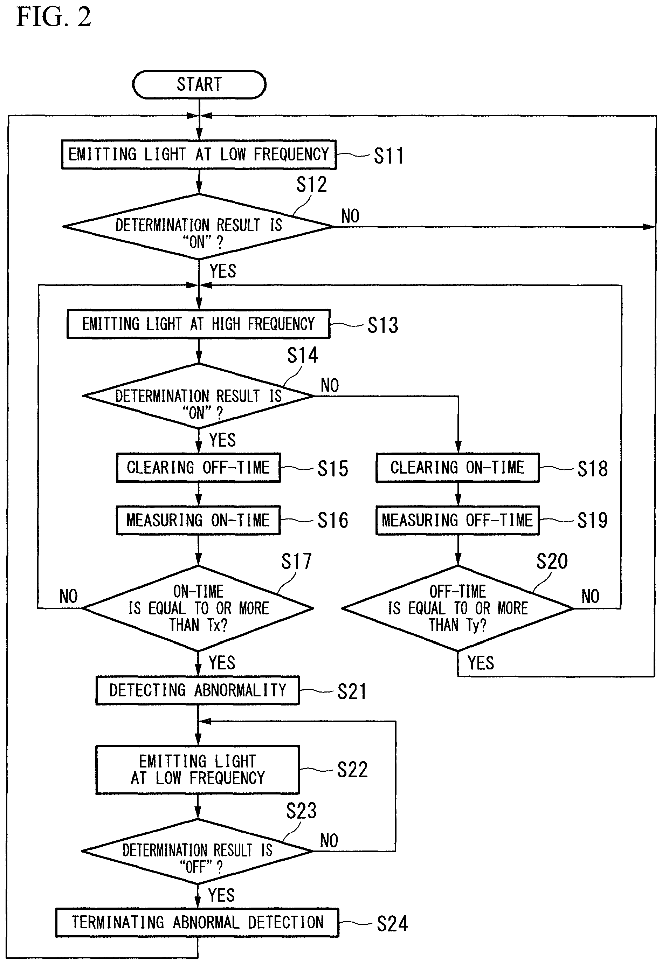

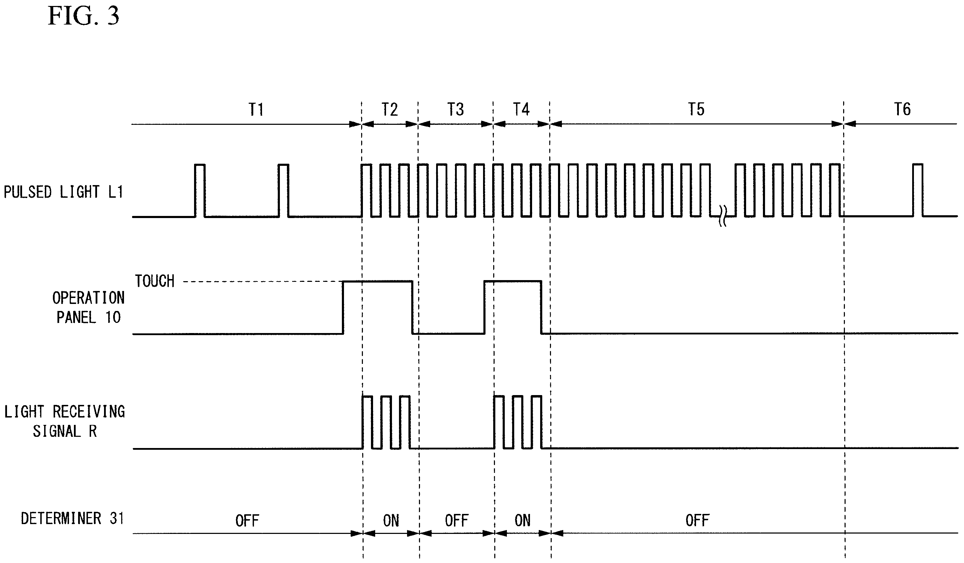

Next, operations of the field device 1 having such configuration will be described. Hereinafter, the optical switch disposed in the field device 1 (the touch switch which is equipped with the emitter-receiver 20, the determiner 31 of the controller 30, the timer 32, and the frequency setter 33) will be mainly described. FIG. 2 is a flowchart illustrating operations of the optical switch in the present embodiment. FIG. 3 is a drawing illustrating wave shapes of the signals in the optical switch in the present embodiment. For example, the process shown in FIG. 2 is started when the field device 1 is powered on. In an initial state, both the on-time and the off-time of the timer 32 are cleared (initialized).

When the process of the flowchart is started, the light emitter 21 emits light at the low frequency (the first emission frequency f1) (step S11). Specifically, the frequency setter 33 disposed in the controller 30 generates the controlling signal C for setting the emission frequency of the light emitter 21 to the first emission frequency fl. After the setting, the drive waveform generator 23 generates a rectangular-shaped pulse signal having the same frequency as the first emission frequency f1. The drive waveform generator 23 applies the generated signal to the light emitter 21 as the driving signal D. By these processes, the pulsed light L1 of the first emission frequency fl is emitted from the light emitter 21 toward the operation panel 10 (referring to the time period T1 shown in FIG. 3).

Next, the frequency setter 33 determines whether the determination result of the determiner 31 is the "ON" or not (step S12). In a case where the finger F of the user does not touch the predetermined position of the transparent plate 11, the reflected pulsed light L2 is not generated. Therefore, the light receiving signal R is not output from the light receiver 22, and the determination result of the determiner 31 is the "OFF". For the reason, the determination result of the step S12 is "NO", and the light emitter 21 continues to emit the pulsed light L1 at the first emission frequency f1 (referring to the time period T1 shown in FIG. 3).

However, in a case where the finger F of the user touches the predetermined position of the transparent plate 11, the pulsed light L1 emitted from the light emitter 21 is reflected by the finger F, and the reflected pulsed light L2 is generated. When the reflected pulsed light L2 is received by the light receiver 22, the light receiving signal R is output from the light receiver 22, and the determination result of the determiner 31 is the "ON" (referring to the time period T2 shown in FIG. 3). For the reason, the determination result of the step S12 is "YES", and the light emitter 21 emits the pulsed light L1 at the high frequency (the second emission frequency f2) (step S13). Because the reflected pulsed light L2 is generated if the finger F of the user comes close to the transparent plate 11, even if the finger F of the user does not touch the transparent plate 11, the process of the step S13 is executed if the light receiving signal R output from the light receiver 22 exceeds a predetermined threshold.

Specifically, in the step S13, the frequency setter 33 disposed in the controller 30 generates the controlling signal C for setting the emission frequency of the light emitter 21 to the second emission frequency f2. After the setting, the drive waveform generator 23 generates the rectangular-shaped pulse signal having the same frequency as the second emission frequency f2. The drive waveform generator 23 applies the generated signal to the light emitter 21 as the driving signal D. By these processes, the pulsed light L1 of the second emission frequency f2 is emitted from the light emitter 21 to the operation panel 10 (referring to the time period T2 shown in FIG. 3).

Thereafter, the frequency setter 33 determines whether the determination result of the determiner 31 is the "ON" or not (step S14). In a case where the determination result of the step S14 is "YES", the timer 32 clears the off-time (step S15) and starts to count the on-time (step S16). The frequency setter 33 determines whether the on-time counted by the timer 32 is equal to or more than the predetermined time period Tx (for example, about several minutes) (step S17). For example, in the time period T2 shown in FIG. 3, because the on-time is not equal to and is not more than the predetermined time period Tx, the determination result of the step S17 is "NO", and the processes from the step S13 to the step S16 are repeated.

However, in a case where the determination result of the step S14 is "NO", the timer 32 clears the on-time (step S18) and starts to count the off-time (step S19). For example, when the finger F of the user gets away from the predetermined position of the transparent plate 11, the determination result of the step S14 is "NO", and the timer 32 executes the processes of the steps S18 and S19 (referring to the time periods T2 and T3 shown in FIG. 3).

Thereafter, the frequency setter 33 determines whether the off-time counted by the timer 32 is equal to or more than the predetermined time period Ty (for example, about five seconds) (step S20). For example, in the time period T3 shown in FIG. 3, because the off-time is not equal to and is not more than the predetermined time period Ty, the determination result of the step S20 is "NO", and the processes of the steps S13, S14, S18, and S19 are repeated. By these processes, although the finger F of the user gets away from the predetermined position of the transparent plate 11, the light emitter 21 continues to emit the pulsed light L1 at the second emission frequency f2 (referring to the time period T3 shown in FIG. 3).

However, for example, in the time period T5 shown in FIG. 3, the off-time is equal to or more than the predetermined time period Ty. At this time, the determination result of the step 20 is "YES", the light emitter 21 emits light at the low frequency (the first emission frequency f1) (step S11). As described above, in a case where the operation panel has not operated for the predetermined time period Ty, so as not to decrease the life of the light emitting element disposed in the light emitter 21, the light emission frequency of the light emitter 21 is decreased (referring to the time period T6 shown in FIG. 3).

On the other hand, in a case where the determination result of the step S17 is "YES" (in other words, in a case where the on-time counted by the timer 32 is equal to or more than the predetermined time period Tx), the frequency setter 33 detects the occurrence of the abnormality (for example, foreign substances are adhered to the operation panel 10) (step S21). Thereafter, the frequency setter 33 generates the controlling signal C for setting the emission frequency to the low frequency (the first emission frequency f1), and the light emitter 21 emits the pulsed light L1 at the low frequency (the first emission frequency f1) (step S22). In other words, in a case where the abnormality such as the foreign substance adhesion is detected, so as not to decrease the life of the light emitting element disposed in the light emitter 21, the light emission frequency of the light emitter 21 is forcibly decreased.

After the process of the step S22, the frequency setter 33 determines whether the determination result of the determiner 31 is the "OFF" or not (step S23). That is, the frequency setter 33 determines whether the foreign substances adhered to the operation panel 10 are removed or not. In a case where the determination result of the step S23 is "NO", the light emitter 21 continues to emit the pulsed light L1 at the first emission frequency f1. However, in a case where the determination result of the step S23 is "YES", the frequency setter 33 cancels the detected abnormality (step S24), and processing returns to the step S11.

As described above, in the present embodiment, in a case where the operation panel 10 is not operated, the emission frequency of the light emitter 21 is set to the low frequency (the first emission frequency f1), in a case where the operation panel 10 is operated, the emission frequency of the light emitter 21 is set to the high frequency (the second emission frequency f2). After the operation panel 10 is operated, in a case where the operation panel 10 has not been operated for the predetermined time period Ty (for example, about 5 seconds), the frequency setter 33 generates the controlling signal C for setting the emission frequency of the light emitter 21 to the low frequency (the first emission frequency f1). By these processes, in the present embodiment, the life of the optical switch can be extended, and the responsiveness of the optical switch can be improved.

In the present embodiment, in a case where it is determined that the operation panel 10 have been operated for the predetermined time period Tx (for example, about several minutes), the frequency setter 33 detects the abnormality such as the foreign substance adhesion, and the frequency setter 33 generates the controlling signal C for setting the emission frequency of the light emitter 21 to the low frequency (the first emission frequency f1). By these processes, the life of the optical switch can be extended, and the responsiveness of the optical switch can be improved.

Although the optical switch, the field device, and the control method of the optical switch according to embodiments of the present invention have been described above, the present invention is not restricted to the above-described embodiments, but is limited only by the scope of the appended claims. For example, in the present embodiment, although the time period Tx used for determining the length of the on-time and the time period Ty used for determining the length of the off-time are fixed, the Tx and the Ty may be changed. For example, the frequency setter 33 may change the time period Ty in accordance with operation contents and screen transition of the operation panel 10. Specifically, in a case where the operation panel 10 is used for selecting or setting a parameter, because there is a high possibility that the operation panel 10 is continued to operate, the time period Ty may be set to be longer. On the other hand, in a case where the operation panel 10 is used for instructing the end of setting the parameter, because there is a high possibility that the operation panel 10 is not continued to operate, the time period Ty may be set to be shorter.

In the present embodiment, although the emission frequency of the light emitter 21 is set to either the first emission frequency f1 or the second emission frequency f2, the emission frequency of the light emitter 21 may be set to one of three or more frequencies. For example, a high frequency is set while the operation panel 10 is operated, a middle frequency is set while a predetermined period after the operation panel 10 is operated, and thereafter a low frequency is set. The emission frequency of the light emitter 21 may be continuously changed in accordance with a length of time that has elapsed since the operation panel was operated.

In the present embodiment, a part (the determiner 31, the timer 32, and the frequency setter 33) of the optical switch is disposed in the controller 30 which totally controls the operation of the field device 1. However, the part of the optical switch may be separated from the controller 30 which totally controls the operation of the field device 1.

The field device 1 in which the optical switch is disposed may perform a wired communication with a control unit (not shown) via a network or a communication bus (not shown). The field device 1 may also perform a wireless communication in conformity with an industrial wireless communication standard such as ISA100.11a and WirelessHART (registered trademark).

## Claims

1. An optical switch comprising:
a light emitter (21) configured to emit a pulsed light (L1) at a predetermined emission frequency toward an operation panel (10) operated by a user ;
a light receiver (22) configured to receive a pulsed light (L2) reflected from the operation panel (10), the light receiver (22) being configured to generate a light receiving signal (R) in response to receipt of the pulsed light (L2); and
a controller (30) configured to receive the light receiving signal (R) from the light receiver (22), the controller (30) being configured to generate, in accordance with the light receiving signal (R), a controlling signal (C) for controlling the emission frequency of the light emitter (21),
wherein the controller (30) comprises:
a determiner (31) configured to determine whether the operation panel (10) is operated or not in accordance with the light receiving signal (R) received from the light receiver (22); and
a frequency setter (33) configured to generate the controlling signal (C) in accordance with a result of determination made by the determiner (31),
**characterized in that**
the frequency setter (33) is configured to generate the controlling signal (C) for lowering the emission frequency of the light emitter (21) from a second emission frequency (f2) to a first emission frequency (f1) in a case where the determiner (31) determines that a time period during which the operation panel (10) is operated becomes equal to or more than a predetermined time period (Tx).

2. The optical switch according to claim 1, wherein
in a case where the result of the determination made by the determiner (31) is a first result representing that the operation panel is not operated, the frequency setter (33) is configured to generate the controlling signal (C) for setting the emission frequency of the light emitter (21) to the first emission frequency (f1), and
in a case where the result of the determination made by the determiner (31) changes from the first result to a second result representing that the operation panel is operated, the frequency setter (33) is configured to generate the controlling signal (C) for setting the emission frequency of the light emitter (21) to the second emission frequency (f2) which is higher than the first emission frequency (f1).

3. The optical switch according to claim 2, wherein
in a case where the result of the determination made by the determiner (31) is the first result during all of a predetermined first time period (Ty) after the frequency setter (33) generates the controlling signal (C) for setting the emission frequency of the light emitter (21) to the second emission frequency (f2), the frequency setter (33) is configured to generate the controlling signal (C) for setting the emission frequency of the light emitter (21) to the first emission frequency (f1).

4. The optical switch according to claim 2, wherein
in a case where the result of the determination made by the determiner (31) is the second result during all of a predetermined second time period (Tx), the frequency setter (33) is configured to generate the controlling signal (C) for setting the emission frequency of the light emitter (21) to the first emission frequency (f1).

5. The optical switch according to claim 4, wherein
the frequency setter (33) is configured to keep the first emission frequency (f1) until the result of the determination made by the determiner (31) becomes the first result.

6. The optical switch according to claim 3, wherein
the frequency setter (33) is configured to generate the controlling signal (C) for changing the first time period (Ty) in accordance with operation contents of the operation panel (10).

7. The optical switch according to claim 2, wherein
the frequency setter (33) is configured to store the first emission frequency (f1) and the second emission frequency (f2), and the frequency setter (33) is configured to change at least one of the first emission frequency (f1) and the second emission frequency (f2) in accordance with an instruction from an external device.

8. A field device comprising:
an operation panel (10) configured to be operated by a user; and
the optical switch according to claim 1.

9. A control method of an optical switch comprising:
emitting, by a light emitter (21), a pulsed light (L1) at a predetermined emission frequency toward an operation panel (10) operated by a user ;
receiving, by a light receiver (22), a pulsed light (L2) reflected from the operation panel (10);
generating, by the light receiver (22), a light receiving signal (R) in response to receipt of the pulsed light (L2);
receiving, by a controller (30), the light receiving signal (R) from the light receiver (22);
generating, by the controller (30), in accordance with the light receiving signal (R), a controlling signal (C) for controlling the emission frequency of the light emitter (21);
determining, by a determiner (31), whether the operation panel (10) is operated or not in accordance with the light receiving signal (R) received from the light receiver (22); and
generating, by a frequency setter (33), the controlling signal (C) in accordance with a result of determination made by the determiner (31),
**characterized by**
generating, by the frequency setter (33), the controlling signal (C) for lowering the emission frequency of the light emitter (21) from a second emission frequency (f2) to a first emission frequency (f1) in a case where the determiner (31) determines that a time period during which the operation panel (10) is operated becomes equal to or more than a predetermined time period (Tx).

## Patentansprüche

1. Ein optischer Schalter, aufweisend:
einen Lichtemitter (21), der konfiguriert ist, um ein gepulstes Licht (L1) mit einer vorbestimmten Emissionsfrequenz in Richtung eines Bedienfeldes (10) zu emittieren, das von einem Benutzer bedient wird;
einen Lichtempfänger (22), der konfiguriert ist, um ein von dem Bedienfeld (10) reflektiertes gepulstes Licht (L2) zu empfangen, wobei der Lichtempfänger (22) konfiguriert ist, um als Reaktion auf den Empfang des gepulsten Lichts (L2) ein Lichtempfangssignal (R) zu erzeugen; und
eine Steuerung (30), die konfiguriert ist, um das Lichtempfangssignal (R) von dem Lichtempfänger (22) zu empfangen, wobei die Steuerung (30) konfiguriert ist, um in Übereinstimmung mit dem Lichtempfangssignal (R) ein Steuersignal (C) zum Steuern der Emissionsfrequenz des Lichtemitters (21) zu erzeugen,
wobei die Steuerung (30) aufweist:
eine Bestimmungseinrichtung (31), die konfiguriert ist, um in Übereinstimmung mit dem von dem Lichtempfänger (22) empfangenen Lichtempfangssignal (R) zu bestimmen, ob das Bedienfeld (10) bedient wird oder nicht; und
eine Frequenzeinstelleinrichtung (33), die konfiguriert ist, um das Steuersignal (C) in Übereinstimmung mit einem Ergebnis der durch die Bestimmungseinrichtung (31) durchgeführten Bestimmung zu erzeugen,
**dadurch gekennzeichnet, dass**
die Frequenzeinstelleinrichtung (33) konfiguriert ist, um das Steuersignal (C) zum Absenken der Emissionsfrequenz des Lichtemitters (21) von einer zweiten Emissionsfrequenz (f2) auf eine erste Emissionsfrequenz (f1) in einem Fall zu erzeugen, in dem die Bestimmungseinrichtung (31) bestimmt, dass eine Zeitspanne, während der das Bedienfeld (10) bedient wird, gleich oder größer als eine vorbestimmte Zeitspanne (Tx) wird.

2. Der optische Schalter nach Anspruch 1, wobei
in einem Fall, in dem das Ergebnis der durch die Bestimmungseinrichtung (31) durchgeführten Bestimmung ein erstes Ergebnis ist, das darstellt, dass das Bedienfeld nicht bedient wird, die Frequenzeinstelleinrichtung (33) konfiguriert ist, um das Steuersignal (C) zum Einstellen der Emissionsfrequenz des Lichtemitters (21) auf die erste Emissionsfrequenz (f1) zu erzeugen, und
in einem Fall, in dem sich das Ergebnis der von der Bestimmungseinrichtung (31) durchgeführten Bestimmung von dem ersten Ergebnis auf ein zweites Ergebnis ändert, das darstellt, dass das Bedienfeld bedient wird, die Frequenzeinstelleinrichtung (33) konfiguriert ist, um das Steuersignal (C) zum Einstellen der Emissionsfrequenz des Lichtemitters (21) auf die zweite Emissionsfrequenz (f2) zu erzeugen, die höher als die erste Emissionsfrequenz (f1) ist.

3. Der optische Schalter nach Anspruch 2, wobei
in einem Fall, in dem das Ergebnis der von der Bestimmungseinrichtung (31) durchgeführten Bestimmung das erste Ergebnis während der gesamten vorbestimmten ersten Zeitspanne (Ty) ist, nachdem die Frequenzeinstelleinrichtung (33) das Steuersignal (C) zum Einstellen der Emissionsfrequenz des Lichtemitters (21) auf die zweite Emissionsfrequenz (f2) erzeugt, die Frequenzeinstelleinrichtung (33) konfiguriert ist, um das Steuersignal (C) zum Einstellen der Emissionsfrequenz des Lichtemitters (21) auf die erste Emissionsfrequenz (f1) zu erzeugen.

4. Der optische Schalter nach Anspruch 2, wobei
in einem Fall, in dem das Ergebnis der durch die Bestimmungseinrichtung (31) durchgeführten Bestimmung das zweite Ergebnis während der gesamten vorbestimmten zweiten Zeitspanne (Tx) ist, die Frequenzeinstelleinrichtung (33) konfiguriert ist, um das Steuersignal (C) zum Einstellen der Emissionsfrequenz des Lichtemitters (21) auf die erste Emissionsfrequenz (f1) zu erzeugen.

5. Der optische Schalter nach Anspruch 4, wobei
die Frequenzeinstelleinrichtung (33) konfiguriert ist, um die erste Emissionsfrequenz (f1) zu halten, bis das Ergebnis der durch die Bestimmungseinrichtung (31) durchgeführten Bestimmung das erste Ergebnis wird.

6. Der optische Schalter nach Anspruch 3, wobei
die Frequenzeinstelleinrichtung (33) konfiguriert ist, um das Steuersignal (C) zum Ändern der ersten Zeitspanne (Ty) in Übereinstimmung mit Betriebsinhalten des Bedienfelds (10) zu erzeugen.

7. Der optische Schalter nach Anspruch 2, wobei
die Frequenzeinstelleinrichtung (33) konfiguriert ist, um die erste Emissionsfrequenz (f1) und die zweite Emissionsfrequenz (f2) zu speichern, und die Frequenzeinstelleinrichtung (33) konfiguriert ist, um mindestens eine der ersten Emissionsfrequenz (f1) und der zweiten Emissionsfrequenz (f2) in Übereinstimmung mit einer Anweisung von einer externen Vorrichtung zu ändern.

8. Ein Feldgerät, aufweisend:
ein Bedienfeld (10), das konfiguriert ist, um von einem Benutzer bedient zu werden; und
den optischen Schalter nach Anspruch 1.

9. Ein Verfahren zur Steuerung eines optischen Schalters, aufweisend:
Emittieren, durch einen Lichtemitter (21), eines gepulsten Lichts (L1) mit einer vorbestimmten Emissionsfrequenz in Richtung eines Bedienfeldes (10), das von einem Benutzer bedient wird;
Empfangen, durch einen Lichtempfänger (22), eines gepulsten Lichts (L2), das von dem Bedienfeld (10) reflektiert wird;
Erzeugen, durch den Lichtempfänger (22), eines Lichtempfangssignals (R) in Reaktion auf den Empfang des gepulsten Lichts (L2);
Empfangen, durch eine Steuerung (30), des Lichtempfangssignals (R) von dem Lichtempfänger (22);
Erzeugen, durch die Steuerung (30), in Übereinstimmung mit dem Lichtempfangssignal (R), eines Steuersignals (C) zum Steuern der Emissionsfrequenz des Lichtemitters (21);
Bestimmen, durch eine Bestimmungseinrichtung (31), ob das Bedienfeld (10) bedient wird oder nicht, in Übereinstimmung mit dem Lichtempfangssignal (R), das von dem Lichtempfänger (22) empfangen wird; und
Erzeugen, durch eine Frequenzeinstelleinrichtung (33), des Steuersignals (C) in Übereinstimmung mit einem Ergebnis der durch die Bestimmungseinrichtung (31) durchgeführten Bestimmung,
**gekennzeichnet durch**
Erzeugen, durch die Frequenzeinstelleinrichtung (33), des Steuersignals (C) zum Absenken der Emissionsfrequenz des Lichtemitters (21) von einer zweiten Emissionsfrequenz (f2) auf eine erste Emissionsfrequenz (f1) in einem Fall, in dem die Bestimmungseinrichtung (31) bestimmt, dass eine Zeitspanne, während der das Bedienfeld (10) bedient wird, gleich oder größer als eine vorbestimmte Zeitspanne (Tx) wird.

## Revendications

1. Commutateur optique comprenant :
un émetteur de lumière (21) configuré pour émettre une lumière pulsée (L1) à une fréquence d'émission prédéterminée vers un panneau de fonctionnement (10) mis en fonctionnement par un utilisateur ;
un récepteur de lumière (22) configuré pour recevoir une lumière pulsée (L2) réfléchie depuis le panneau de fonctionnement (10), le récepteur de lumière (22) étant configuré pour générer un signal de réception de lumière (R) en réponse à la réception de la lumière pulsée (L2) ; et
un dispositif de commande (30) configuré pour recevoir le signal de réception de lumière (R) depuis le récepteur de lumière (22), le dispositif de commande (30) étant configuré pour générer, en conformité avec le signal de réception de lumière (R), un signal de commande (C) pour commander la fréquence d'émission de l'émetteur de lumière (21),
dans lequel le dispositif de commande (30) comprend :
un dispositif de détermination (31) configuré pour déterminer si le panneau de fonctionnement (10) est mis en fonctionnement ou non en conformité avec le signal de réception de lumière (R) reçu depuis le récepteur de lumière (22) ; et
un dispositif de réglage de fréquence (33) configuré pour générer le signal de commande (C) en conformité avec un résultat de détermination établi par le dispositif de détermination (31),
**caractérisé en ce que**
le dispositif de réglage de fréquence (33) est configuré pour générer le signal de commande (C) afin d'abaisser la fréquence d'émission de l'émetteur de lumière (21) d'une deuxième fréquence d'émission (f2) à une première fréquence d'émission (f1) dans un cas où le dispositif de détermination (31) détermine qu'une période pendant laquelle le panneau de fonctionnement (10) est mis en fonctionnement devient supérieure ou égale à une période prédéterminée (Tx).

2. Commutateur optique selon la revendication 1, dans lequel
dans un cas où le résultat de la détermination établi par le dispositif de détermination (31) est un premier résultat représentant le fait que le panneau de fonctionnement n'est pas mis en fonctionnement, le dispositif de réglage de fréquence (33) est configuré pour générer le signal de commande (C) afin de régler la fréquence d'émission de l'émetteur de lumière (21) à la première fréquence d'émission (f1), et
dans un cas où le résultat de la détermination établi par le dispositif de détermination (31) change du premier résultat à un deuxième résultat représentant le fait que le panneau de fonctionnement est mis en fonctionnement, le dispositif de réglage de fréquence (33) est configuré pour générer le signal de commande (C) afin de régler la fréquence d'émission de l'émetteur de lumière (21) à la deuxième fréquence d'émission (f2) qui est plus élevée que la première fréquence d'émission (f1).

3. Commutateur optique selon la revendication 2, dans lequel
dans un cas où le résultat de la détermination établi par le dispositif de détermination (31) est le premier résultat pendant la totalité d'une première période prédéterminée (Ty) après la génération par le dispositif de réglage de fréquence (33) du signal de commande (C) pour régler la fréquence d'émission de l'émetteur de lumière (21) à la deuxième fréquence d'émission (f2), le dispositif de réglage de fréquence (33) est configuré pour générer le signal de commande (C) afin de régler la fréquence d'émission de l'émetteur de lumière (21) à la première fréquence d'émission (f1).

4. Commutateur optique selon la revendication 2, dans lequel
dans un cas où le résultat de la détermination établi par le dispositif de détermination (31) est le deuxième résultat pendant la totalité d'une deuxième période prédéterminée (Tx), le dispositif de réglage de fréquence (33) est configuré pour générer le signal de commande (C) afin de régler la fréquence d'émission de l'émetteur de lumière (21) à la première fréquence d'émission (f1).

5. Commutateur optique selon la revendication 4, dans lequel
le dispositif de réglage de fréquence (33) est configuré pour conserver la première fréquence d'émission (f1) jusqu'à ce que le résultat de la détermination établi par le dispositif de détermination (31) devienne le premier résultat.

6. Commutateur optique selon la revendication 3, dans lequel
le dispositif de réglage de fréquence (33) est configuré pour générer le signal de commande (C) afin de changer la première période (Ty) en conformité avec un contenu de fonctionnement du panneau de fonctionnement (10).

7. Commutateur optique selon la revendication 2, dans lequel
le dispositif de réglage de fréquence (33) est configuré pour stocker la première fréquence d'émission (f1) et la deuxième fréquence d'émission (f2), et le dispositif de réglage de fréquence (33) est configuré pour changer au moins l'une de la première fréquence d'émission (f1) et de la deuxième fréquence d'émission (f2) en conformité avec une instruction provenant d'un dispositif externe.

8. Dispositif de champ comprenant :
un panneau de fonctionnement (10) configuré pour être mis en fonctionnement par un utilisateur ; et
le commutateur optique selon la revendication 1.

9. Procédé de commande d'un commutateur optique comprenant :
l'émission, par un émetteur de lumière (21), d'une lumière pulsée (L1) à une première fréquence d'émission prédéterminée vers un panneau de fonctionnement (10) mis en fonctionnement par un utilisateur ;
la réception, par un récepteur de lumière (22), d'une lumière pulsée (L2) réfléchie depuis le panneau de fonctionnement (10) ;
la génération, par le récepteur de lumière (22), d'un signal de réception de lumière (R) en réponse à la réception de la lumière pulsée (L2) ;
la réception, par un dispositif de commande (30), du signal de réception de lumière (R) depuis le récepteur de lumière (22) ;
la génération, par le dispositif de commande (30), en conformité avec le signal de réception de lumière (R), d'un signal de commande (C) pour commander la fréquence d'émission de l'émetteur de lumière (21) ;
la détermination, par un dispositif de détermination (31), du fait que le panneau de fonctionnement (10) est mis en fonctionnement ou non en conformité avec le signal de réception de lumière (R) reçu depuis le récepteur de lumière (22) ; et
la génération, par un dispositif de réglage de fréquence (33), du signal de commande (C) en conformité avec un résultat de détermination établi par le dispositif de détermination (31),
**caractérisé par**
la génération, par le dispositif de réglage de fréquence (33), du signal de commande (C) afin d'abaisser la fréquence d'émission de l'émetteur de lumière (21) d'une deuxième fréquence d'émission (f2) à une première fréquence d'émission (f1) dans un cas où le dispositif de détermination (31) détermine qu'une période pendant laquelle le panneau de fonctionnement (10) est mis en fonctionnement devient supérieure ou égale à une période prédéterminée (Tx).
